**Europäisches Patentamt**

(19) **European Patent Office**

**Office européen des brevets**

(11) Numéro de publication: **0 089 276**
**B1**

(12) ## FASCICULE DE BREVET EUROPEEN

(45) Date de publication du fascicule du brevet:
06.08.86

(21) Numéro de dépôt: **83400468.1**

(22) Date de dépôt: **07.03.83**

(51) Int. Cl.⁴: **H 04 L 7/02, H 03 L 7/08**

(54) Dispositif de récupération de fréquence d'horloge en transmission numérique.

(30) Priorité: **15.03.82 FR 8204343**

(43) Date de publication de la demande:
**21.09.83 Bulletin 83/38**

(45) Mention de la délivrance du brevet:
**06.08.86 Bulletin 86/32**

(84) Etats contractants désignés:
**DE IT NL SE**

(56) Documents cités:
**WO - A - 80/01630**

**IEEE TRANSACTIONS ON AEROSPACE AND ELECTRONIC SYSTEMS, vol. AES-10, no. 5, septembre 1974, pages 643-647, New York, USA, I.L. BRUYLAND: "Optimum acquisition of the idling first-order phase-locked loop"**
**NACHRICHTENTECHNIK-ELEKTRONIK, vol. 25, no. 8, août 1975, pages 296-301, Berlin, DE., L. HARMS: "Wirkungsweise und Anwendung von Phasen- und Frequenzregelkreisen - eine Übersicht"**
**IEEE TRANSACTIONS ON VEHICULAR TECHNOLOGY, vol. VT-29, no. 4, novembre 1980, pages 353-360, New York, USA, R.J. TURNER: "Evaluation of cellular mobile telephone data receivers"**

(73) Titulaire: **THOMSON-CSF, 173, Boulevard Haussmann, F-75379 Paris Cedex 08 (FR)**

(72) Inventeur: **Collin, Claude, THOMSON-CSF SPCI 173, bld Haussmann, F-75379 Paris Cedex 08 (FR)**
Inventeur: **Faydit, Joel, THOMSON-CSF SPCI 173, bld Haussmann, F-75379 Paris Cedex 08 (FR)**
Inventeur: **Pinsard, Hervé, THOMSON-CSF SPCI 173, bld Haussmann, F-75379 Paris Cedex 08 (FR)**

(74) Mandataire: **Weinmiller, Jürgen, Zeppelinstrasse 63, D-8000 München 80 (DE)**

## Description

L'invention se rapporte à la transmission d'informations numériques en milieux fortement perturbés et a plus particulièrement pour objet un dispositif de récupération de fréquence d'horloge, utilisé dans les équipements de transmission d'informations numériques entre deux stations terminales en visibilité ou non, la liaison étant assurée le plus souvent par propagation troposphérique ou ionosphérique.

Les liaisons de ce type présentent une atténuation de propagation très variable en fonction du temps. Pour assurer en permanence la transmission des informations, il n'est pas rentable, et il est même souvent impossible, de mettre en œuvre des équipements ayant une marge de transmission suffisante pour que le signal puisse être restitué lors d'une atténuation de propagation maximale, ces conditions de propagation étant rencontrées pendant un très faible pourcentage de temps. Classiquement, de tels équipements de transmission comportent plusieurs voies de transmission en parallèle dont les caractéristiques, fréquences porteuses par exemple, sont suffisamment distinctes pour ne pas être affectées simultanément par une même atténuation de propagation. Un tel fonctionnement en diversité permet de combiner les signaux issus des différentes voies avec des coefficients de pondération automatiquement ajustés afin d'obtenir à chaque instant une qualité de liaison au moins égale à celle de la voie présentant la meilleure qualité à un instant donné.

L'ordre de diversité étant limité, il subsiste des périodes de propagation difficile particulièrement en diffusion troposphérique ou ionosphérique. Pendant ces périodes variables de quelques millisecondes à quelques secondes, le signal démodulé et combiné est de très mauvaise qualité: le rapport signal à bruit obtenu est très faible et peut tendre vers zéro. Or ce signal démodulé et combiné, de type analogique, doit être régénéré sous forme numérique. Pour cela il est aiguillé sur deux voies:
- une voie de récupération d'horloge,
- et une voie de régénération, cette régénération étant effectuée à partir de l'horloge récupérée.

La figure 4 de l'article de R.J. Turner «Evaluation of Cellular Mobile Telephone Data Receivers», paru dans la revue américaine «IEEE Transactions on Vehicular Technology», vol. VT–29, Novembre 1980, pages 353–360, montre un dispositif de régénération de fréquence d'horloge comportant un circuit analogique de redressement dont la sortie est reliée à un circuit de filtrage de bande et utilisant un circuit oscillateur commandé par une boucle d'asservissement de phase comportant un comparateur de phase.

Après régénération, l'équipement de transmission restitue les deux signaux qu'il a la charge de transmettre: le train numérique contenant l'information et l'horloge en phase avec ce train numérique. Ces deux signaux sont alors exploités par l'équipement de traitement numérique, l'horloge étant généralement utilisée pour la synchronisation du traitement numérique.

Le bon fonctionnement de ces équipements d'exploitation est subordonné au maintien de leur synchronisme et donc au maintien de l'horloge récupérée à partir duquel est obtenu le synchronisme.

En présence d'évanouissements profonds dûs à la propagation, il est absolument nécessaire dans ce type d'équipements de maintenir une horloge récupérée de bonne qualité.

Or dans les équipements classiques, ces évanouissements profonds se traduisent par l'apparition d'une gigue de phase sur l'horloge bit récupérée; cette gigue de phase rend le signal inexploitable lorsqu'elle dépasse une certaine valeur car les dispositifs de récupération de fréquence d'horloge utilisés ne sont pas optimisés pour un fonctionnement à très faible rapport signal à bruit, les circuits employés présentant fréquemment un effet de seuil en présence de bruit élevé. Cet effet de seuil est dû au fait que les circuits généralement utilisés sont des circuits logiques, en particulier le comparateur de phase qui, en présence de bruit, délivre un signal de sortie présentant des sauts de tension qui entraînent des perturbations sur la fréquence commandée. Généralement ces circuits logiques, non linéaires, ne fonctionnent pas lorsque le rapport signal à bruit est de l'ordre de quelques dB. De plus, si une coupure du signal reçu intervient, les dispositifs classiques entraînent une disparition de l'horloge.

La présente invention a pour objet un dispositif de récupération de l'horloge qui ne présente pas les inconvénients mentionnés ci-dessus et tel que:
- la fréquence horloge récupérée présente une gigue de phase négligeable;
- l'horloge bit est maintenue en présence de coupures du signal reçu pouvant atteindre plusieurs secondes, le déphasage résultant étant inférieur à ¼ de bit, afin que ce signal reste exploitable;
- le retour à la phase initiale lors de la réapparition du signal reçu s'effectue en un temps très inférieur à la durée de la coupure.

L'invention se rapporte à un dispositif de récupération de la fréquence d'horloge en transmission numérique, du type comportant un circuit analogique de redressement, pour faire apparaître dans le signal une composante à la fréquence du rythme d'horloge, dont la sortie est reliée à un circuit de filtrage de bande, et un circuit à oscillateur à quartz commandé par une boucle d'asservissement de phase comportant un comparateur de phase, caractérisé en ce que ledit circuit de filtrage de bande est un circuit de filtrage à bande très étroite, en ce que ledit comparateur de phase est un comparateur de phase de type analogique, ayant ses entrées couplées à la sortie du circuit de filtrage et à la sortie de l'oscillateur et ayant sa sortie couplée à l'entrée de commande de phase de l'oscillateur, ce comparateur de phase délivrant un signal d'erreur nul lorsque les signaux sur ses deux entrées ont une relation de phase prédéterminée ou lorsque le signal de sortie du circuit de filtrage est nul.

La figure 1 est un schéma synoptique du dispositif de récupération d'horloge suivant l'invention.

La figure 2 est la caractéristique du comparateur de phase utilisé dans cette boucle de phase.

La figure 3 est un schéma détaillé d'un mode de réalisation de la boucle de phase du circuit de récupération décrit en référence à la figure 1.

Dans les solutions classiques, les signaux reçus et démodulés sont combinés et le signal combiné est transmis à l'entrée du dispositif de récupération de fréquence d'horloge comportant un limiteur, des circuits de mise en forme et un générateur d'impulsions, ces circuits étant des circuits logiques, suivi d'un filtre de bande ayant une bande passante de l'ordre de $10^{-2}$ de la fréquence d'horloge, suivi d'un comparateur de phase logique et d'une boucle de phase classique. Comme indiqué ci-dessus, ce type de dispositifs ne fonctionne pas pour les très faibles rapports signal à bruit.

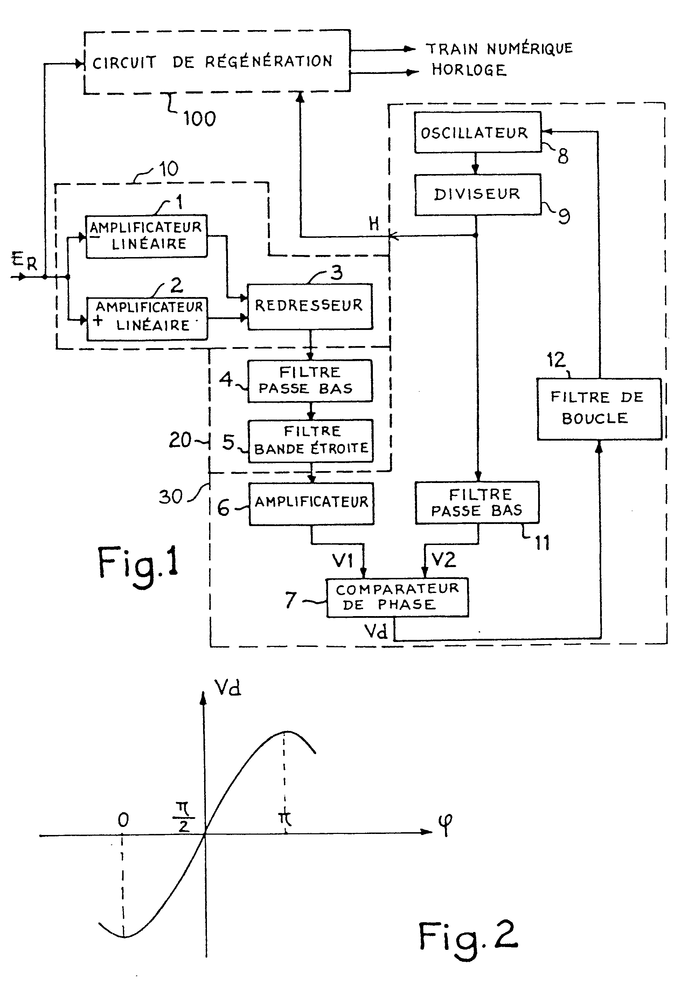

La figure 1 représente le dispositif de récupération d'horloge suivant l'invention. Il comporte une entrée de signal $E_R$, à laquelle est appliqué le signal démodulé et combiné résultant de la combinaison des signaux reçus dans plusieurs voies en diversité. Cette entrée est reliée à l'entrée d'un circuit de redressement 10 du signal reçu qui comporte deux amplificateurs linéaires 1 et 2 en parallèle ayant des sorties inversées reliées aux entrées d'un redresseur double alternance à diodes, 3.

Dans ce premier circuit les impulsions en forme de demi-sinusoïdes provenant du signal démodulé sont amplifiées puis redressées. Il apparaît ainsi de l'énergie à la fréquence du rythme numérique: par exemple pour un rythme numérique de 100 k bit/s, il apparaît de l'énergie à la fréquence f = 100 kHz. Contrairement aux circuits de mise en forme logiques, ce circuit ne présente pas d'effet de seuil. La sortie du redresseur 3 est reliée à un circuit de filtrage, 20, qui comporte un filtre pasce-bas 4, dont la fréquence de coupure est légèrement supérieure à la fréquence d'horloge. Ce premier filtre permet d'éliminer les harmoniques de la fréquence d'horloge. La sortie de ce filtre passe-bas 4 est reliée à l'entrée d'un filtre passe-bande 5, de bande très étroite centrée sur la fréquence d'horloge. Sa bande passante est de l'ordre de $10^{-4}$ de la fréquence d'horloge. Par exemple, pour une fréquence d'horloge de 100 kHz la bande passante du filtre 5 est de l'ordre de 10 Hz. Ce filtrage très étroit permet une amélioration importante du rapport signal à bruit à la sortie. En effet, la puissance de bruit est intégrée dans une bande de 10 Hz seulement, au lieu du bruit dans la bande de 100 kHz existant à l'entrée du dispositif. Ce filtre peut être constitué par exemple d'un quartz utilisé à la résonance série, l'accord étant effectué par un condensateur ajustable série et la bande passante étant fixée par une résistance série. Le signal de sortie du filtre passe-bande 5 est donc un signal sinusoïdal sans gigue de phase notable pour les très faibles rapports signal à bruit. De plus lors d'une coupure du signal reçu, en cas d'évanouissement profond par exemple, le signal ne décroît que progressivement en sortie du filtre du fait de la constante de temps de ce filtre associée à sa bande passante très étroite.

Le signal de sortie de ce filtre sert de référence à un circuit 30 à oscillateur commandé par une boucle d'asservissement de phase ayant des propriétés particulières. Ce circuit 30 comporte un amplificateur 6, dont l'entrée est reliée à la sortie du filtre passe-bande 5, la sortie de cet amplificateur étant reliée à la première entrée d'un comparateur de phase de type analogique 7. Ce circuit comporte en outre un oscillateur à quartz 8, VCXO, asservi en phase sur la fréquence d'horloge issue du filtre passebande 5 au moyen d'une boucle de phase constituée de la manière suivante: la sortie de l'oscillateur 8 est reliée à l'entrée d'un diviseur à circuit logique 9 dont la sortie est reliée à l'entrée d'un filtre passe-bas 11. La sortie de ce filtre passe-bas est reliée à la seconde entrée du comparateur de phase du type analogique 7. La sortie de ce comparateur de phase est reliée à l'entrée d'un amplificateur avec filtre de boucle 12 dont la sortie est reliée à l'entrée de commande de phase de l'oscillateur 8.

La sortie du diviseur 9, fournit à un circuit de régénération, 100, une horloge H au rythme des bits, ayant une relation de phase prédéterminée avec le signal reçu.

Ce circuit fonctionne de la manière suivante: L'oscillateur VCXO, 8, délivre à partir d'un oscillateur à quartz asservi en phase sur le signal de sortie de l'amplificateur 6, un signal logique de fréquence F. Si $f = \frac{F}{n}$ est le rythme de l'horloge bit du train numérique reçu, le diviseur 9 est un diviseur par n qui fournit l'horloge récupérée au rythme bit. Si la fréquence de l'oscillateur est le rythme bit, le diviseur 9 n'a pas lieu d'être. Cette horloge bit récupérée est appliquée à l'entrée du filtre passe-bas 11 qui fournit à la seconde entrée du comparateur de phase analogique 7, un signal sinusoïdal qui est comparé en phase au signal de sortie de l'amplificateur 6.

Si $V_1$ est la tension de sortie de l'amplificateur 6, et $V_2$ la tension de sortie du filtre passe-bas 11, la tension de sortie $V_d$ du comparateur de phase de type analogique est de la forme: $V_d = kV_1 V_2 \cos \varphi$, ou $\varphi$ est l'écart de phase entre la sortie de l'amplificateur 6 et la sortie du filtre passe-bas 11, k étant une constante.

Cette tension d'erreur $V_d$ est nulle d'une part lorsque le décalage de phase entre les signaux présents sur ces deux entrées est égal à $\frac{\pi}{2}$, et d'autre part lorsque la tension de sortie de l'amplificateur 6, $V_1$ est nulle.

La figure 2 représente cette tension d'erreur $V_d$ en fonction de l'écart de phase $\varphi$. Le fonctionnement de la boucle de phase est le suivant:

En présence de signal reçu, la boucle de commande de phase asservit la phase de l'oscillateur 8 sur celle du signal de sortie de l'amplificateur 6, $V_1$, de telle manière que la tension d'erreur $V_d$ soit nulle, ceci étant obtenu lorsque le signal d'horloge est en phase avec la référence à $\frac{\pi}{2}$ près.

Lors d'une coupure de la transmission, le signal en sortie de l'amplificateur 6 est constitué par du bruit fortement réduit par rapport au bruit à l'entrée par la traversée du filtre passe-bande 5, du fait que sa bande passante est de l'ordre de $10^{-4}$ du rythme d'horloge. La tension de bruit résultant présente à l'entrée du comparateur de phase, $V_1$ est très voisine de 0 volt. De ce fait la tension d'erreur $V_d$ est également très voisine de 0 volt. En conséquence, lors d'une telle coupure de la transmission, il n'y a pas de saut de tension à la sortie du comparateur de phase, la tension restant à une valeur quasiment nulle.

De plus, dans le mode de réalisation décrit ci-après, l'amplificateur et le filtre de boucle 12 ainsi que l'oscillateur 8 sont conçus de façon que la phase du signal de sortie de l'oscillateur 8 ne dérive que très lentement lors d'une coupure de la transmission.

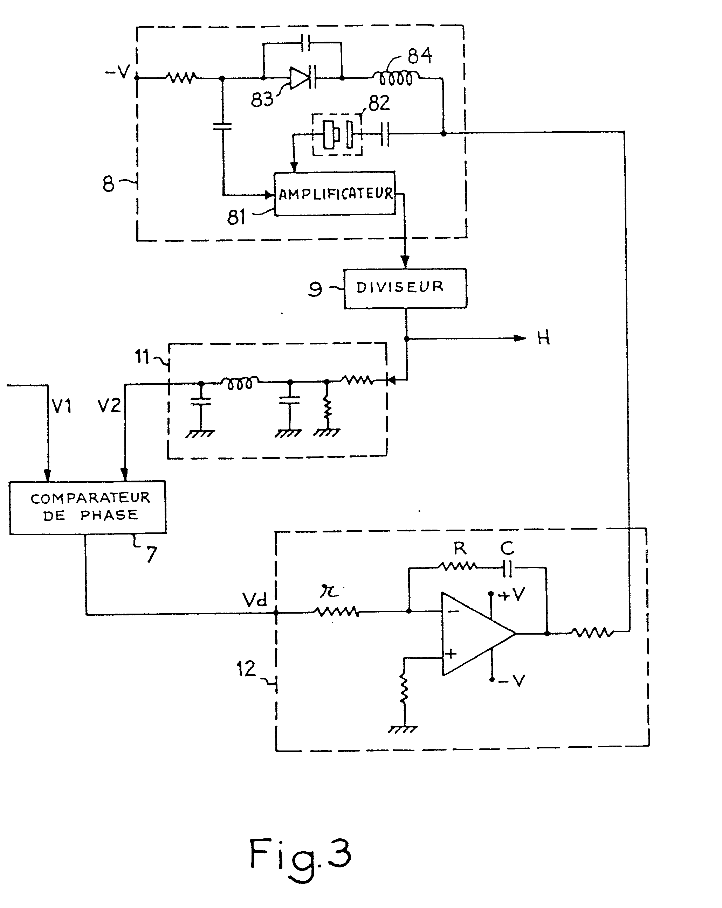

La figure 3 représente les détails d'un mode de réalisation de la boucle de phase permettant d'obtenir ce résultat:

L'amplificateur à filtre de boucle 12 est un amplificateur différentiel à l'entrée «moins» duquel est appliquée, par l'intermédiaire d'une résistance r, la tension d'erreur $V_d$, et dont la sortie est reliée à cette même entrée par un circuit à résistance R et condensateur C en série réalisant le filtre de boucle.

L'oscillateur 8 comporte un amplificateur 81 associé à un quartz 82, sa commande de phase étant réalisée par un varactor 83, c'est-à-dire une diode polarisée en inverse, dont la capacité varie avec la tension appliquée, en série avec une inductance 84. La tension appliquée au varactor commandant la fréquence de l'oscillateur 8 est la tension de sortie de l'amplificateur à filtre de boucle 12. Lors d'une coupure de la transmission, le signal de référence $V_1$ est quasiment égal à 0, et l'asservissement de phase n'agit plus. Par contre, le condensateur C de forte valeur, plusieurs microfarads, se décharge à travers la diode varactor polarisée en inverse dont la résistance est très forte (plusieurs mégohms). La constante de temps de ce circuit est très élevée et la variation de la tension à la sortie de l'amplificateur différentiel reste négligeable sur quelques secondes; en conséquence la fréquence de l'oscillateur reste également stable et seule une faible dérive de phase en résulte. Classiquement pour que les systèmes de traitement qui suivent un tel circuit de récupération fonctionnent convenablement, on impose généralement un déphasage de l'horloge bit inférieur à un quart de bit sur plusieurs secondes. Cette caractéristique peut être obtenue sans difficulté à l'aide du dispositif de récupération suivant l'invention.

Lorsque le signal réapparaît après une coupure de la transmission, le signal de référence $V_1$ est présent. L'asservissement entre en action rapidement par suite du gain de boucle élevé (défini par le rapport R/r). La tension $V_d$ étant très voisine de 0 volt lors de la coupure, la montée de la tension $V_1$ se fait progressivement du fait du filtre passe-bande 5. Il en résulte que la phase du signal horloge, H, revient à sa valeur nominale sans discontinuité.

Ce dispositif permet donc à l'équipement de transmission de restituer l'horloge à l'équipement de traitement des informations numériques même lors de mauvaises conditions de propagation.

Ce dispositif s'applique comme indiqué ci-dessus à la transmission d'informations numériques en milieux fortement perturbés et donc surtout aux liaisons sans visibilité pour radiocommunications troposphériques ou ionosphériques et également aux radiocommunications à partir de véhicules mobiles.

## Revendications

1. Dispositif de récupération de la fréquence d'horloge en transmission numérique, du type comportant un circuit analogique de redressement (10), pour faire apparaître dans le signal une composante à la fréquence du rythme d'horloge, dont la sortie est reliée à un circuit de filtrage de bande (20), et un circuit à oscillateur à quartz (8) commandé par une boucle d'asservissement de phase comportant un comparateur de phase (7), caractérisé en ce que ledit circuit de filtrage de bande (20) est un circuit de filtrage à bande très étroite, et en ce que ledit comparateur de phase est un comparateur de phase de type analogique ayant ses entrées couplées à la sortie du circuit de filtrage (20) et à la sortie de l'oscillateur (8) et ayant sa sortie couplée à l'entrée de commande de phase de l'oscillateur, ce comparateur de phase délivrant un signal d'erreur nul lorsque les signaux sur ses deux entrées ont une relation de phase prédéterminée ou lorsque le signal de sortie du circuit de filtrage est nul.

2. Dispositif selon la revendication 1, caractérisé en ce que l'oscillateur (8) est commandé en fréquence par un varactor (83), ayant une forte résistance interne et en ce que la boucle de phase comporte un filtre de boucle avec un condensateur de forte valeur (C) qui se décharge lentement à travers le varactor lors des coupures de transmission, l'horloge récupérée (H) ne dérivant que d'une fraction de période lors de coupures de l'ordre d'une seconde.

3. Dispositif selon la revendication 2, caractérisé en ce que le gain de boucle est choisi élevé, ce qui permet le retour rapide de la phase du signal d'horloge à sa valeur nominale, sans discontinuité, après une coupure de transmission.

4. Dispositif selon l'une quelconque des revendications précédentes, caractérisé en ce que le circuit de redressement (10) comporte deux amplificateurs linéaires en parallèle (1, 2) ayant des sorties inversées reliées aux entrées d'un redresseur à diodes double alternance (3).

5. Dispositif selon l'une quelconque des revendications précédentes, caractérisé en ce que le circuit de filtrage (20) comporte un filtre passe-bas d'entrée (4) suivi d'un filtre (5) centré sur la fréquence du rythme d'horloge dont la bande très étroite est de l'ordre de 10⁻⁴ de la fréquence d'horloge.

**Patentansprüche**

1. Schaltungsanordnung zur Taktfrequenz-Wiedergewinnung bei der Digitalübertragung, mit einem analogen Gleichrichterkreis (10), der im Signal eine Komponente mit der Taktfrequenz deutlich werden lässt und dessen Ausgang an einen Bandfilterkreis (20) angeschlossen ist, und mit einem Quarzoszillatorkreis (8), der über eine Phasenregelschleife mit einem Phasenkomparator (7) geregelt wird, dadurch gekennzeichnet, dass der Bandfilterkreis (20) ein sehr schmales Band ausfiltert und dass der Phasenkomparator vom analogen Bautyp ist und mit seinen Eingängen an den Ausgang des Filterkreises (20) und an den Ausgang des Oszillators (8) sowie mit seinem Ausgang an den Phasenregeleingang des Oszillators angekoppelt ist, wobei dieser Phasenkomparator ein Fehlersignal Null liefert, wenn die Signale an seinen beiden Eingängen eine vorgegebene Phasenbeziehung besitzen oder wenn das Ausgangssignal des Filterkreises Null ist.

2. Schaltungsanordnung nach Anspruch 1, dadurch gekennzeichnet, dass die Frequenz des Oszillators (8) von einem Varaktor (83) mit grossem Innenwiderstand gesteuert wird und dass die Phasenschleife ein Schleifenfilter mit einem Kondensator grosser Kapazität (C) aufweist, der sich während der Unterbrechungen der Übertragung langsam über den Varaktor entlädt, wobei der wiedergewonnene Takt (H) während Unterbrechungen in der Grössenordnung einer Sekunde nur um den Bruchteil einer Periode abweicht.

3. Schaltungsanordnung nach Anspruch 2, dadurch gekennzeichnet, dass die Schleifenverstärkung gross gewählt wird, so dass eine schnelle Rückkehr der Phase des Taktsignals auf den Nennwert, ohne Diskontinuität, nach einer Übertragungsunterbrechung möglich ist.

4. Schaltungsanordnung nach einem beliebigen der vorhergehenden Ansprüche, dadurch gekennzeichnet, dass der Gleichrichterkreis (10) zwei lineare Verstärker (1, 2) in Parallelschaltung enthält, deren inverse Ausgänge an die Eingänge eines Zweiweg-Diodengleichrichters (3) angeschlossen sind.

5. Schaltungsanordnung nach einem beliebigen der vorhergehenden Ansprüche, dadurch gekennzeichnet, dass der Filterkreis (20) eingangsseitig ein Tiefpassfilter (4) aufweist, gefolgt von einem auf die Frequenz des Taktsignals zentrierten Filter (5), dessen sehr schmale Bandbreite in der Grössenordnung von 10⁻⁴ der Taktfrequenz liegt.

**Claims**

1. A clock frequency recovery device for the digital transmission, of the type comprising an analog rectifying circuit (10) for causing a clock frequency component to appear in the signal, the output of said rectifying circuit being connected to a band filter circuit (20), and a quartz oscillator circuit (8) controlled by a phase-control loop including a phase comparator (7), characterized in that said bandfilter (20) is of the very narrow band width type, and that said phase comparator is of the analog type having its inputs coupled to the output of the band filter circuit (20) and to the output of the oscillator (8), and having its output coupled to the phase control input of the oscillator, said phase comparator being adapted to deliver a zero error signal, if the signals on its two inputs have a predetermined phase relationship or if the output signal of the band filter circuit is zero.

2. A device according to claim 1, characterized in that the oscillator (8) is frequency-controlled by a varactor (83) having a high internal resistance, and that the phase loop comprises a loop filter with a high-value (C) capacitor which discharges slowly through the varactor during interruptions of transmission, the drift of the recovered clock signal (H) being only a fraction of a period for interruption intervals of the order of one second.

3. A device according to claim 2, characterized in that said loop has a high loop gain so as to permit a rapid return of the clock signal phase to its normal value without any discontinuity after an interruption of transmission.

4. A device according to any one of the preceding claims, characterized in that the rectifying circuit (10) comprises two linear amplifiers (1, 2) in parallel having inverted outputs connected to the inputs of a full-wave diode rectifier (3).

5. A device according to any one of the preceding claims, characterized in that the filtering circuit (20) comprises a low-pass input filter (4) followed by a filter (5) centered on the clock frequency and having a very narrow band, of the order of 10⁻⁴ of the clock frequency.

Fig.1

Fig.2

Fig.3